Europäisches Patentamt

(19) European Patent Office

Office européen des brevets

(11) Numéro de publication : **0 291 400 B1**

(12) **FASCICULE DE BREVET EUROPEEN**

(45) Date de publication du fascicule du brevet :
26.06.91 Bulletin 91/26

(51) Int. Cl.⁵ : **H05K 7/20**

(21) Numéro de dépôt : 88401126.3

(22) Date de dépôt : 09.05.88

(54) **Module de puissance pour équipements automobiles.**

(30) Priorité : 15.05.87 FR 8706837

(43) Date de publication de la demande :
17.11.88 Bulletin 88/46

(45) Mention de la délivrance du brevet :
26.06.91 Bulletin 91/26

(84) Etats contractants désignés :
DE ES GB IT

(56) Documents cités :
EP-A- 0 080 156
EP-A- 0 085 622
DE-B- 1 063 226

(73) Titulaire : **VALEO ELECTRONIQUE**
**12-14, Rue Jean Bart**
**F-78960 Voisins-Le-Bretonneux (FR)**

(72) Inventeur : **Boucheron, Jean-Louis**
**6, Hameau du Rougeau**
**F-77176 Savigny-le-Temple (FR)**

(74) Mandataire : **Lemaire, Marc et al**
**VALEO Département Propriété Industrielle 30,**
**rue Blanqui**
**F-93406 Saint-Ouen (FR)**

## Description

La présente invention concerne une forme de réalisation d'un module de puissance destiné à équiper des véhicules automobiles. Celle-ci intègre une partie comportant des composants de puissance nécessitant l'utilisation de refroidisseurs.

Du document EP-A-0085622 est connu un assemblage d'un circuit imprimé et des circuits intégrés encapsulés, sur un drain thermique métallique.

La présente invention concerne l'association des éléments de puissance avec le refroidisseur et la façon dont sont effectuées les liaisons.

A cet effet, le module de puissance, comprenant un circuit imprimé assemblé rigidement sur un refroidisseur sur lequel sont déposés par collage ou soudure directement une ou plusieurs pastilles de silicium de puissance afin de permettre une évacuation et une répartition des calories entre les différentes pastilles, la liaison électrique entre les différentes plages de sorties des pastilles de silicium et les connexions étant effectuées par soudure ultrasonique d'un fil d'aluminium entre les plages de sorties des pastilles de silicium elles-mêmes et le circuit imprimé qui permet ainsi le passage du courant vers un connecteur raccordé directement à celui-ci, la partie refroidisseur sur laquelle se trouve rapportées les pastilles de silicium comporte des extrudés lui permettant d'assurer sa propre liaison avec le circuit imprimé.

L'invention sera bien comprise à la lecture de la description suivante faite en se référant au dessin annexé dans lequel :

– la figure 1 est une vue schématique en perspective d'un module selon un exemple de réalisation de l'invention, et

– la figure 2 est une vue en coupe d'une partie du module de la figure 1.

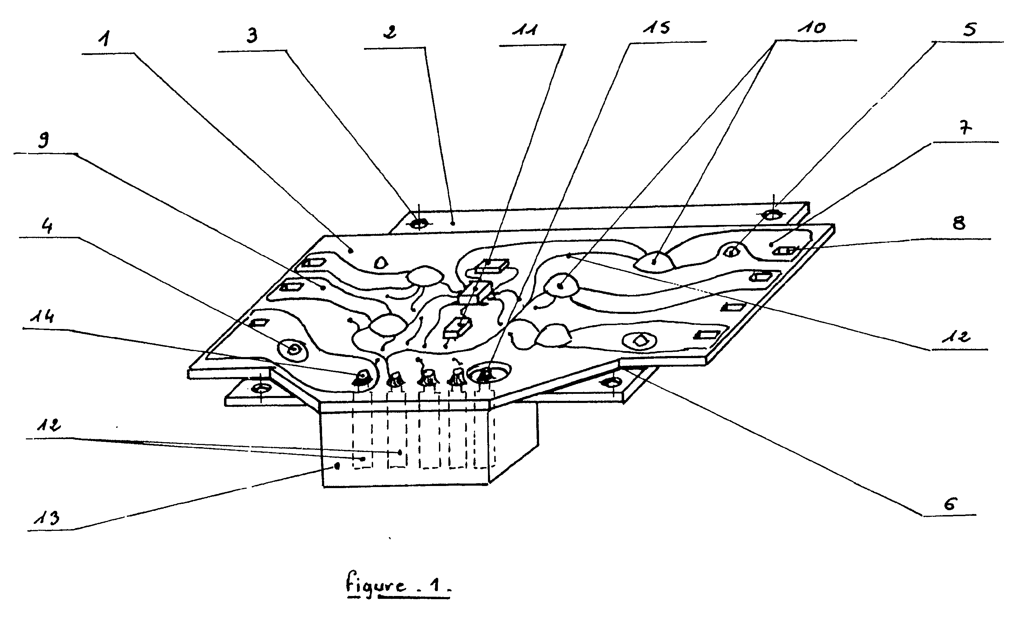

Dans la forme de réalisation de la figure 1, on trouve un assemblage composé d'un circuit imprimé 1, assemblé sur un refroidisseur 2 qui peut être en cuivre nickelé.

Ce refroidisseur peut comporter des trous de fixation 3 ou tout autre moyen pouvant servir à fixer le module dans le site où celui-ci sera utilisé.

Le circuit imprimé 1 et le refroidisseur 2 sont assemblés de manière rigide par des tétons écrasés 4 et 5 assurant un sertissage entre les deux parties.

Dans certains cas, si le circuit imprimé 1 comporte des pistes côté refroidisseur 2, on peut intercaler entre les deux parties un isolant 6.

Celui-ci pourrait être remplacé par un vernis isolant sur le cuivre du circuit imprimé 1.

Le circuit imprimé 1 comporte des plages de raccordement de puissance 7 sur l'extérieur ainsi que divers moyens de positionnement et de raccordement qui peuvent être des encoches, des trous ou des découpes 8.

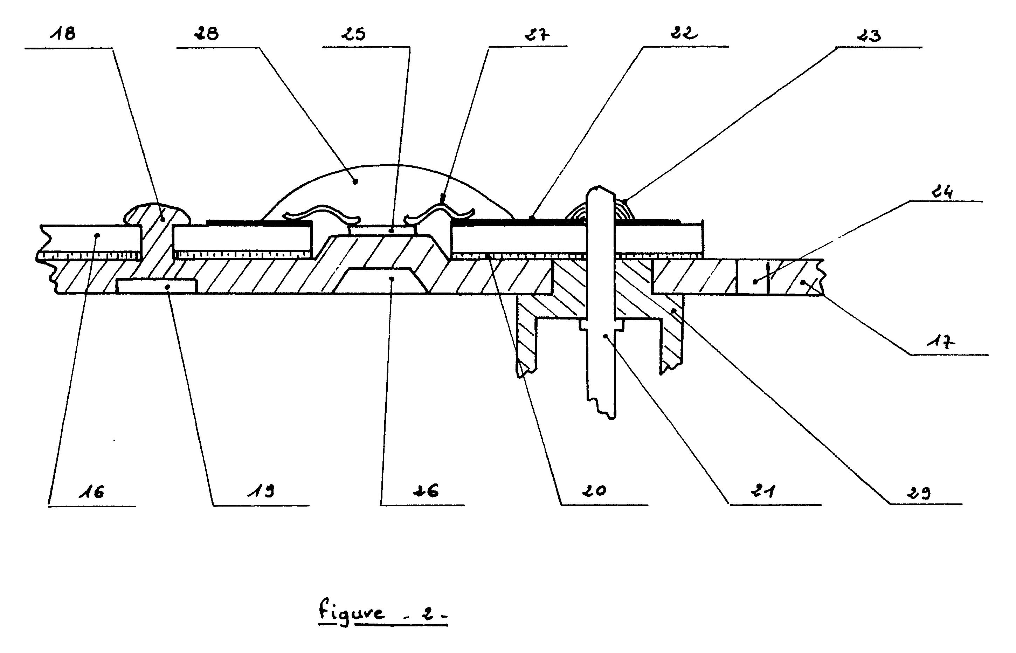

Ces plages de raccordement 7 sont reliées par une piste de puissance 9 à des composants de puissance 10 dont on ne voit pas le détail sur la figure 1 mais qui sont plus clairement représentés sur la figure 2.

Le circuit imprimé 1 comporte également d'autres composants 11 qui peuvent être du type C.M.S., composants qui sont reliés entre eux suivant un schéma approprié par des pistes de faible largeur 12, aux composants de puissance, et à diverses languettes 12 d'un connecteur 13 par soudure à l'étain 14.

Il convient de remarquer que toutes les soudures peuvent être effectuées d'un seul coup par une technique telle que la soudure à la vague.

Dans la forme de réalisation représentée à la figure 1, il est également possible qu'une ou plusieurs languettes 15 du connecteur 13 ne soit pas raccordée au circuit imprimé mais au refroidisseur.

Dans ce cas, le circuit imprimé 1 comportera un dégagement permettant ce raccordement.

L'assemblage entre le refroidisseur 2 et le circuit imprimé 1 nécessite d'être isolé. C'est pourquoi le pion 5 est évité par la piste 7 avoisinante, et le pion 4 est isolé de la piste réalisant la liaison aboutissant sur la languette 14.

La figure 2 représente une coupe brisée du module dans laquelle on peut voir le circuit imprimé 16, serti sur la plaque refroidisseur 17 par un pion de sertissage 18 obtenu directement à partir de la plaque refroidisseur par matriçage 19.

L'isolant 20 nécessaire si le circuit imprimé est à double face sans protection figure entre le circuit imprimé et le refroidisseur.

Une connexion 21 est raccordée au cuivre de la face supérieure 22 du circuit imprimé 16 par de la soudure 23.

Un boîtier 29 protège celle-ci et forme le connecteur.

Un trou de fixation 24 fait partie du refroidisseur. Celui-ci pourrait également appartenir au circuit imprimé seul, ou au sandwich circuit imprimé-refroidisseur.

La pastille de silicium du composant de puissance 25 est rapportée directement par collage ou soudure sur le refroidisseur qui peut comporter un emboutissage de mise à niveau 26.

Les connexions sont réalisées par un procédé traditionnel entre la puce et les plages de raccordement 27 du circuit imprimé.

Enfin, une goutte de résine époxy assure le maintien et la protection de la pastille et de ses connexions en réalisant un enrobage local 28.

Le refroidisseur peut être un élément métallique moulé muni d'ailettes de refroidissement.

## Revendications

1. Module de puissance, comprenant un circuit imprimé (1, 16) assemblé rigidement sur un refroidisseur (2, 17) sur lequel sont déposés par collage ou soudure directement une ou plusieurs pastilles de silicium de puissance (10, 25) afin de permettre une évacuation et une répartition des calories entre les différentes pastilles (10, 25), la liaison électrique entre les différentes plages de sorties (7, 9) des pastilles de silicium (10, 25) et les connexions du circuit imprimé étant effectuées par soudure ultrasonique d'un fil d'aluminium entre les plages de sorties (7, 9) des pastilles de silicium (10, 25) elles-mêmes et le circuit imprimé (1, 16) qui permet ainsi le passage du courant vers un connecteur (13) raccordé directement à celui-ci, la partie refroidisseur (2) sur laquelle se trouve rapportées les pastilles de silicium (10) comporte des pions (4, 5) lui permettant d'assurer sa propre liaison avec le circuit imprimé (1).

2. Module de puissance suivant la revendication 1, caractérisé par le fait que la partie refroidisseur (2) comporte des emboutissages (26) permettant d'obtenir une remise à niveau des pastilles de silicium (25) par rapport au circuit imprimé, et diverses ouvertures (3, 8) permettant soit la fixation soit le passage de liaisons isolées.

3. Module de puissance selon l'une des revendications 1 et 2, caractérisé par le fait que le refroidisseur (2, 17) est un élément métallique moulé comportant des ailettes destinées au refroidissement de la pièce.

## Ansprüche

1. Leistungsmodul, enthaltend eine gedruckte Schaltung (1, 16), die starr an einem Kühler (2, 17) angebracht ist, worauf direkt eine oder mehrere Silicium-Leistungsplättchen (10, 25) aufgeklebt oder aufgeschweißt sind, um eine Abführung und Verteilung der Kalorien zwischen den verschiedenen Plättchen (10, 25) zu ermöglichen, wobei die elektrische Verbindung zwischen den Ausgangsbereichen (7, 9) der Siliciumplättchen (10, 25) und die Verbindungen der gedruckten Schaltung durch Ultraschallverschweißung eines Alu-Drahts zwischen den Ausgangsbereichen (7, 9) der Siliciumplättchen (10, 25) selbst und der gedruckten Schaltung (1, 16) hergestellt werden, so daß der Strom zu einem direkt daran angeschlossenen Stecker (13) gelangen kann, während der Kühlteil (2), woran die Siliciumplättchen (10) angebracht sind, über Stifte (4, 5) verfügt, die dessen eigene Verbindung zur gedruckten Schaltung (1) gewährleisten.

2. Leistungsmodul nach Anspruch 1, **dadurch gekennzeichnet**, daß der Kühlteil (2) Prägungen (26) aufweist, wodurch die Siliciumplättchen (25) auf die Höhe der gedruckten Schaltung gebracht werden können und mehrere Öffnungen (3, 8) entweder die Befestigung oder den Durchtritt isolierter Verbindungen erlauben.

3. Leistungsmodul nach den Ansprüchen 1 und 2, **dadurch gekennzeichnet**, daß der Kühler (2, 17) ein gepreßtes Metallelement ist, welches Rippen enthält, die für die Kühlung des Teils bestimmt sind.

## Claims

1. A power module comprising a printed circuit (1, 16) assembled rigidly on a cooler (2, 17) on which one or more silicon power chips (10, 25) are directly applied by adhesion or soldering, so as to enable heat to be removed and distributed between the different chips (10, 25), with the printed circuit connections being effected by ultrasonic soldering of an aluminium wire between the output portions (7, 9) of the silicon chips (10, 25) themselves and the printed circuit (1, 16), which thus enables current to pass to a connector (13) which is joined directly to the latter, and with the cooling member portion (2) on which the silicon chips (10) are carried including pins (4, 5) which ensure its own connection with the printed circuit (1).

2. A power module according to Claim 1, characterised by the fact that the cooling member (2) includes depressions whereby the level of the silicon chips (25) may be offset with respect to the printed circuit, and various openings (3, 8) enabling insulated connections either to be secured or to be passed through.

3. A power module according to Claim 1 or Claim 2, characterised by the fact that the cooler (2, 17) is a moulded metallic element having fins for cooling the member.

figure . 1 .

EP 0 291 400 B1

Figure - 2 -